# EUROPEAN PATENT SPECIFICATION

(11) **EP 3 925 012 B1**
(45) Date of publication and mention of the grant of the patent: **07.05.2025**
(21) Application number: 20711311.9
(22) Date of filing: 31.01.2020
(51) Int. Cl.: H01L 31/054, H02S 40/22, H01L 31/042, H02S 20/00

(54) **SOLAR PANEL COLUMN**
SOLARPANEELSÄULE
COLONNE DE PANNEAUX SOLAIRES

(30) Priority: 13.02.2019 HU 1900046
(43) Date of publication of application: 22.12.2021
(73) Proprietor: Szilágyi, József, 4027 Debrecen (HU)
(72) Inventor: Szilágyi, József, 4027 Debrecen (HU)
(86) International application number: PCT/IB2020/050777
(87) International publication number: WO 2020/165682

(56) References cited:
- DE-A1- 2 525 630
- DE-A1- 3 937 019
- US-A- 4 411 490
- US-A- 5 575 860
- US-A1- 2008 115 830
- US-A1- 2015 034 144
- US-A1- 2015 214 408

## Description

The patent application relates to a solar panel column, which is a device working on the principle of photovoltaic effect, producing direct current, and which comprises a support structure with a support tube in the centre, having a closed side and containing a plurality of levels parallel to one another. Solar panels are placed on the levels, between the levels there are parabolic mirrors covering the solar panels, and to these solar panels light is provided by a bundle of optical fibres consisting of end-glow optical fibres, amplified by the parabolic mirrors.

The utilization of solar energy, as renewable energy, is an important task of our time. Its advantage is that, as a renewable energy source, it is always available and can be utilized without the emission of harmful substances. Solar energy is utilized both as thermal energy and as electrical energy. Nowadays the use of solar collectors for converting solar radiation into heat and solar panels for converting sunlight into electrical energy is becoming more and more widespread.

Solar panel-based systems are widely used in institutions, homes or even for the operation of individual devices powered by electricity, such as garden lights, parking meters, or smart clothes.

In order to increase the efficiency of solar panels, installations or solar parks consisting of solar panels connected in series are installed on roofs or larger unbuilt areas, depending on the characteristics of the available area. These systems are fixed, they can only be used at the site of installation, and at the same time require a large area, which is often not available.

There are areas, where electrical energy is only needed temporarily, this task can be solved by using portable solar panels, several such solutions are disclosed in the prior art.

Due to the potentials offered by solar panels, the structural design of solar-panel-based systems is constantly in the focus of development, there is an increasing need for portable devices having a small floor area.

Patent Application No. US20110023939 discloses a portable solar cell apparatus including a base, a plurality of solar cell units, a light guide element, and a plurality of lens units. The solar cell units are disposed at the base. The light guide element has a plurality of integrally formed funnel-shaped light guide units. The light guide element is disposed at the base, and each of the funnel-shaped light guide units guides light to the respective solar cell unit. Each of the lens units is disposed at the respective funnel-shaped light guide unit.

Patent Application No. US4433199 discloses a system for solar energy acquisition, in which light concentrated by means a parabolic reflector, then by passing through a prism, is directed to photovoltaic cells by means of a multiplicity of fiber optic bundles for energy efficient power generation.

Patent Application No. US20110083721A1 relates to a concentrating photovoltaic system including a parabolic mirror focusing a beam of light on an array of photovoltaic cells. The array of photovoltaic cells includes a plurality of triangular shaped individual photovoltaic cells arranged like slices of a pie, defining an octagon, and a plurality of trapezoidal shaped solar cells are arranged around the perimeter of the triangular shaped solar cells. The light reflected by the parabolic mirror consisting of a large number of small plane mirrors travels to the array of photovoltaic cells mounted on top of a support through a bundle of optical fibres arranged around the support, amplified by it.

Patent Application No. US20140319327 relates to a solar concentrator assembly including a light splitting element, a light converging element, an optical fibre unit, and a photoelectric unit in such a way that the individual units are located on top of one another. An optical fibre of the optical fibre unit is connected to each photoelectric converter of the photoelectric unit. Light travels to the photoelectric converters placed next to one another through optical fibres placed next to one another.

The DE 39 37 01 9 Al patent discloses a compact variable photovoltaic power plant equipped with a multi-modular sunlight sensor and solar cell system, where the PV panels are in stacked configuration, and each PV panel level is illuminated by an optical fiber. The optical fibers are bounded in an optical fiber bundle, that is connected to a lens optic. The light is focused by the lens optics and is directed by the optical fiber bundle. Each optical fiber in the boundle is connected to an emitting device that focuses light at the level of the PV panel

A disadvantage of the above solutions is that their spatial location is not favourable, and they do not have high mobility.

The aim of the invention is to provide a solar panel column, which is a portable device of any size and shape, has a small floor area, provides good space utilization, and can be operated with both natural and artificial light.

Another aim is to allow the utilization of light energy in vehicles, or other confined spaces.

The invention is based on the recognition that the power of solar panels can be increased not only by increasing the surface of the solar panels in direct contact with light, but also by providing a column with solar panels installed on levels located under one another, and by transmitting light between the levels by means of end-glow optical fibres.

In order to ensure sufficient light intensity between the levels and thereby the production of sufficient power, the ends of the end-glow optical fibres introduced between two levels are specially designed.

Thus the invention relates to a solar panel column for the production of direct current as defined in claim 1, the main elements of which are a support structure, solar panels, a bundle of optical fibres and parabolic mirrors.

The support structure consists of spacer boxes with closed side walls, placed on top of one another, and levels formed between the spacer boxes. A support tube is fixed in the centre of the support structure.

The levels parallel to one another, formed between the spacer boxes, consist of a lower mounting frame and an upper mounting frame, which have the same floor area, and which are fixed to each other preferably by mounting screws. The lower mounting frames have openings and a circular bore in the centre, with the exception of the lower mounting frame located at the bottom of the support structure, which has no openings. The upper mounting frame has an open centre portion, its edges fit exactly the edges of the lower mounting frame.

The spacer boxes of the support structure, placed on top of one another, have the same floor area, they have closed side walls, and their open bottom portion is closed by an upper mounting frame, while their open top portion is closed by a lower mounting frame. The solar panels are placed on the lower mounting frames, and are covered by the upper mounting frames. The parabolic mirrors fit the upper mounting frames in such a way that their lower portion covers the solar panels completely.

The support tube is located in the centre of the support structure, passes through the bores of the lower mounting frames, and is fixed to the lowermost lower mounting frame.

A bundle of optical fibres is fixed to the support tube located in the centre of the support structure, surrounding the support tube.

The bundle of optical fibres consists of end-glow optical fibres. The bundle of optical fibres consisting of end-glow optical fibres covers the whole length of the support tube, but the length of the outermost optical fibres of the bundle of optical fibres is different, they end in different places. The design of the bundle of optical fibres consisting of end-glow optical fibres and fixed to the support tube is characterized by the alternation of cylindrical portions and truncated cone-shaped portions of the bundle of optical fibres. The truncated cone-shaped portions are formed by cutting and grinding the outermost optical fibres of the bundle of optical fibres, thereby the outermost optical fibres of the truncated cone-shaped portions consist of the ends of end-glow optical fibres. The truncated cone-shaped portions of the bundle of optical fibres are located between the levels, therefore, as a result of this design, the optical fibre ends illuminate the space between the relevant levels.

The cylindrical portions located at the levels are straight, in the cylindrical portions of the bundle of optical fibres there are no ends of end-glow optical fibres. The height of the cylindrical portions is the same, while the height of the truncated cone-shaped portions preferably increases from section to section from the top towards the bottom. The height of the truncated cone-shaped portions changes to such an extent that the surface area of the truncated cone-shaped portions between any two levels is the same.

The solar panels placed on the uppermost level of the support structure are exposed to natural or artificial light directly. The uppermost level of the support structure can be closed by a cover, which is useful when the solar panel column is transported, or is not in use.

In the solution according to the invention, the lower mounting frames of the support structure, with the exception of the bore, are covered by solar panels fixed by the upper mounting frames. Rectangular solar panels are arranged in the shape of a square on the lower mounting frames in such a way that they leave a square-shaped mounting opening in the centre for the bundle of optical fibres.

The solar panels are covered with foil.

Solar panels located on the same level are connected in parallel, with two pole terminals, and the required voltage levels (e.g. 3, 6, 9, 12, 24, 42 volts) can be achieved by connecting the solar panels located on the levels placed on top of one another in series.

Each level is covered by solar panels, and between two levels there is a square-shaped parabolic mirror with rounded corners, the lower portion of which covers the solar panels. Its curved central, upper portion has a circular flanged opening, through which the bundle of optical fibres passes.

In the solution according to the invention the distance between the levels, the height of the spacer box, and the height of the parabolic mirror is the same as the height of the truncated cone-shaped portion located between the relevant levels.

The solar panels located on the uppermost level of the support structure are exposed to a natural or artificial source of light directly, while light is transmitted to the solar panels located on the other levels by means of the bundle of end-glow optical fibres and parabolic mirrors.

The uppermost level can be covered by a closing element, then the solar panels located on the uppermost level of the support structure are not exposed to light directly. The closing element is fixed to a lower mounting frame placed on the top portion of an additional spacer box. The horizontal portion of the closing element fits exactly the lower mounting frame, and a vertical, tubular portion in the centre holds the bundle of optical fibres extending beyond the support structure.

When the support structure is covered by the closing element, the top portion of the bundle of optical fibres can be connected to another bundle also consisting of end-glow optical fibres, an optical fibre cable. An optical fibre cable consists of sheathed optical fibres fixed around a support element, with the ends of the end-glow optical fibres located in one plane.

An optical fibre cable can be connected to additional optical fibre cables.

The support structures can be formed into various shapes, e.g. a cube, a column, a rectangle, etc., and connected into a block or blocks to achieve higher power levels. Solar panel columns can be connected into a block on a mounting base plate, by clamping screws located at the ends of the support structures. Electrical connection between the support structures can be made safely by wires and voltage regulators, as well as protection devices.

In a preferred embodiment the solar panel column has a support structure consisting of five levels, the levels are parallel to one another, and there are spacer boxes between the levels. There are four rectangular solar panels on the lower mounting frame of each level. The rectangular solar panels are arranged in the shape of a square in such a way that they leave a mounting opening in the centre of the square, which is not covered by the solar panels.

Desiccant silica gel bags are placed in the corners of the square-shaped mounting opening. A bundle of optical fibres passes in the centre of the square-shaped mounting opening formed by the solar panels. There are parabolic mirrors between the levels, the uppermost level does not have a parabolic mirror, as the solar panels on this level are exposed to the rays of light directly.

The bundle of optical fibres consisting of end-glow optical fibres and surrounding a support tube runs along the whole height of the support structure. The diameter of the bundle of optical fibres decreases from the top level towards the lower levels, with alternating straight cylindrical portions and truncated cone-shaped portions. The bundle of optical fibres is layered. The bundle of optical fibres is fixed to the support tube layer by layer, the thickness of the layers of optical fibres is the same, and the bundle of optical fibres consists of as many layers of optical fibres as there are levels in the support structure, which in this embodiment means five layers of optical fibres. The individual layers are held together and separated from one another by shrink tubes.

The spacer boxes have the same floor area, but have different heights, their height increases from the top of the support structure towards bottom, they have closed side walls, and their open bottom portion is closed by an upper mounting frame, while their open top portion is closed by a lower mounting frame.

The height of the spacer box and the parabolic mirror is the same as the height of the truncated cone-shaped portion located between the relevant levels. The height of the truncated cone-shaped portions increases from the top towards the bottom in such a way that the surface area of the truncated cone-shaped portions between any two levels is the same.

Another preferred embodiment differs from the previous embodiment in that the uppermost level is covered by a closing element. The horizontal portion of the closing element fits exactly a lower mounting frame connected to an additional spacer box, and a vertical tubular portion in the centre of the closing element holds the bundle of optical fibres passing through it. The bundle of optical fibres can be connected to an optical fibre cable, and the optical fibre cable can be connected to additional optical fibre cables. An optical fibre cable consists of end-glow optical fibres.

In yet another preferred embodiment, the inlet end of the optical fibre cable of a support structure covered by a closing element is installed in the headlight of a vehicle, or led to the roof of the vehicle, while the support structure itself is located in the engine compartment, or in the rear boot of the vehicle.

In a further preferred embodiment, four support structures are connected into a rectangular block, forming a block of solar panel columns.

The invention will be described in detail with reference to the following figures, without being limited thereto:
Figure 1 shows a longitudinal sectional view of a solar panel column open at the top, consisting of five levels,
Figure 2 shows a top view of the solar panel column open at the top,
Figures 3a and 3b show a side view and a top view of the bundle of optical fibres of the solar panel column,
Figure 4 shows a top view of the arrangement of the solar panels,
Figure 5 shows a side view of a parabolic mirror,
Figure 6 shows a top view of a lower mounting frame,
Figure 7 shows a top view of a spacer box,
Figure 8 shows a top view of the arrangement of silica gel bags,
Figure 9 shows a top view of a support structure covered by a closing element,
Figure 10a shows a longitudinal sectional view of the upper part of the support structure covered by a closing element and an optical fibre cable connected to the bundle of optical fibres,
Figure 10b shows a front view of a mounting stud,
Figure 11 shows an axonometric view of the sheathing of an optical fibre cable,
Figure 12 shows a top view of a mounting clamp,
Figures 13a and 13b show a lateral cross-sectional view and a front view of an optical fibre cable installed in the headlight of a vehicle.

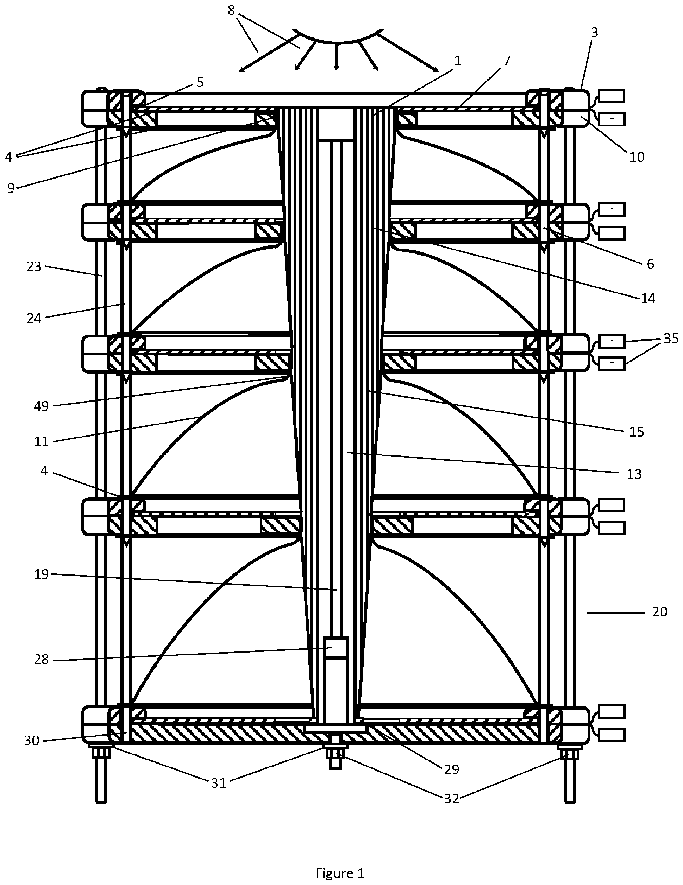

Figure 1 shows a longitudinal sectional view of a solar panel column consisting of five levels. The support structure 20 comprises spacer boxes 24, upper mounting frames 3 and lower mounting frames 10 forming levels, and a support tube 13, which are fixed firmly to one another.

The support structure 20 has levels parallel to one another, each level consists of an upper mounting frame 3 and a lower mounting frame 10, which are fixed to each other and to the spacer boxes 24 by mounting screws 6. The levels located under one another are connected by clamping screws 23. The distance between the levels increases from the top towards the bottom.

The support tube 13 located in the centre of the support structure 20, running along the whole height of the support structure, is fixed to a threaded support stud 28 in the centre of the lower mounting frame 10 of the lowermost level by a self-locking nut 32 with a flat washer 31 from below, and a cylindrical head bolt 19 from above. The lowermost lower mounting frame 10 is fixed by lowermost frame bolts 30. The support tube 13 is held by a support washer 29.

The support tube 13 is made of PVC, the cylindrical head bolt 19, the threaded support stud 28, the flat washer 31 and the self-closing nut 32 are made of stainless material. The spacer boxes 24 are preferably made of coloured cellular polycarbonate.

The support tube 13 is surrounded by a bundle of optical fibres 1. The bundle of optical fibres 1 runs in the centre of the support structure 20, along the whole height thereof. The bundle of optical fibres 1 has - by design - two different types of portions alternating to form the bundle of optical fibres 1: cylindrical portions 14 in the plane of the levels, and truncated cone-shaped portions 15 between the levels. In the shown embodiment there is a cylindrical portion 14 at the uppermost level, followed by a truncated cone-shaped portion 15 between the uppermost level and the level below it. The thickness of the truncated cone-shaped portion 15, measured from the surface of the support tube 13, gradually decreases between the two levels, thus resulting in a truncated cone shape. At the next level it is followed by a cylindrical portion 14, then by a truncated cone-shaped portion 15 again, and so on, all the way down to the lowermost level. The diameter of both the cylindrical portions 14 and the truncated cone-shaped portions 15 decreases from the top towards the bottom, the height of the cylindrical portions 14 is the same, while the height of the truncated cone-shaped portions 15 increases towards the bottom. The cylindrical portions 14 are surrounded by silicone rubber rings 9. The truncated cone-shaped portions 15 are protected by foil 2.

The distance between the levels decreases from the bottom level towards the top level in such a way that the surface area of the truncated cone-shaped portions 15 of the bundle of optical fibres 1 is the same between any two levels.

Solar panels 7 are placed on each lower mounting frame 10 of the support structure 20. The closed surface of each lower mounting frame 10 is covered with silicone sealing rubber 4 having the same shape as the lower mounting frame 10. The solar panels 7 are placed on the silicone sealing rubber 4 providing a flexible cushion. The solar panels 7 are fixed firmly to the lower mounting frame 10 by the upper mounting frame 3. The upper mounting frame 3 closes on the outer edges of the solar panels 7 with liquid silicone rubber 5 sealing. The upper mounting frame 3 and the lower mounting frame 10 are fixed to each other by mounting screws 6. The solar panels 7 are connected in parallel for direct current, with two pole terminals 35 for further connection. The solar panels 7 are covered with foil 2 on each level. Parabolic mirrors 11 are placed between the levels in such a way that their lower portion covers the whole surface of the solar panels 7 located on the relevant level, while the upper, central portion of the parabolic mirror 11, having a flanged opening 49, extends up to the middle of the level located above it, and the flanged opening 49 surrounds the cylindrical portion 14 of the bundle of optical fibres 1.

The lower portion of the parabolic mirror 11 fits the lower mounting frame 10 on the continuation of the silicone sealing rubber 4. The floor area of the parabolic mirrors 11 placed on the various levels is the same, but their height increases from the top towards the bottom. In this embodiment the solar panels 7 placed on the uppermost level are not covered by a parabolic mirror 11.

The surface area of the truncated cone-shaped portions 15 of the bundle of optical fibres 1 is the same between any two levels. The thickness of the bundle of optical fibres 1, measured from the surface of the support tube 13, decreases from level to level from the top towards the bottom, while the height of the truncated cone-shaped portions 15 increases and is the same as the height of the parabolic mirror 11 located on the relevant level.

The ends of the end-glow optical fibres of the truncated cone-shaped portions 15 of the bundle of optical fibres 1 located between two levels illuminate the solar panels 7 and the inner surface of the parabolic mirrors 11 from level to level. The parabolic mirrors 11, acting as reflectors, reflect the light falling on them from the end-glow optical fibres to the solar panels 7 located below them. The parabolic mirrors 11 with silvered inner surface are preferably made of plastic.

In this embodiment the solar panels 7 located on the uppermost level and the top portion of the bundle of optical fibres 1 are exposed to the rays of light 8 directly, while the solar panels 7 located on the lower levels are exposed to light travelling through the bundle of optical fibres 1 and reflected by the parabolic mirrors 11 acting as reflectors.

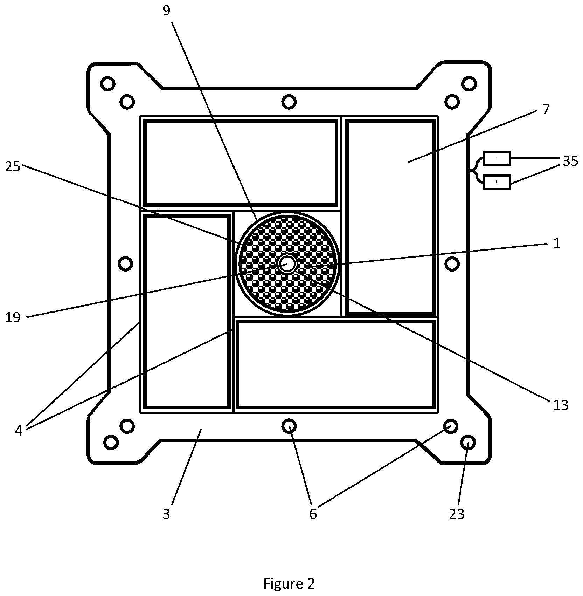

Figure 2 shows a top view of the support structure 20, showing clearly the design of the uppermost level of the support structure 20. On this uppermost level the upper mounting frame 3 fixes four rectangular solar panels 7 to the lower mounting frame 10. The upper mounting frame 3 and the lower mounting frame 10 are fixed to a spacer box 24 by eight mounting screws 6. Both the upper mounting frame 3 and the lower mounting frame are formed with four right-angled tabs at the corners. The tabs allow the assembling of the levels by four clamping screws 23. The upper mounting frames 3 and the lower mounting frames 10 are made of plastic.

In the shown embodiment, the four solar panels 7 are placed side by side in the shape of a square and connected electrically in parallel in such a way that there is silicone sealing rubber 4 between the solar panels 7 and the lower mounting frame 10 and the solar panels 7 and the upper mounting frame 3. There is a square-shaped mounting opening in the centre, which is not covered by the solar panels 7, in this mounting opening a bundle of optical fibres 1 is arranged circularly around a central support tube 13. The bundle of optical fibres 1 is surrounded by a shrink tube 25, the shrink tube 25 covered cylindrical portions 14 of the bundle of optical fibres 1, located at the levels, are surrounded by silicone rubber rings 9. The diameter of the optical fibres forming the bundle of optical fibres 1 can be 0.5, 0.75, 1, 1.25 or 1.5 mm, depending on the dimensions of the solar panel column. The support tube 13 is fixed by a cylindrical head bolt 19.

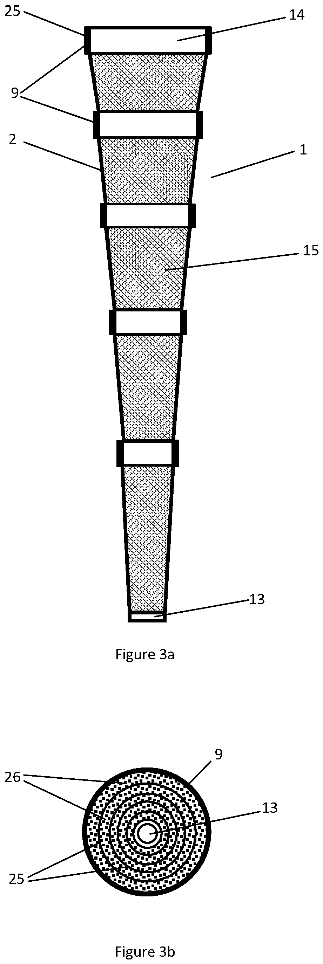

Figures 3a and 3b show a side view and a top view of the bundle of optical fibres 1 of the solar panel column.

As shown in Figure 3a, the diameter of the bundle of optical fibres 1 increases from section to section from the bottom towards the top. The bundle of optical fibres 1 consists of alternating cylindrical portions 14 and truncated cone-shaped portions 15. The truncated cone-shaped portions 15 are covered on the outside with transparent foil 2.

The cylindrical portions 14 are located at the levels of the support structure 20, while the truncated cone-shaped portions 15 are located between the levels.

The bundle of optical fibres 1 is layered, in the case of a support structure 20 consisting of five levels the bundle of optical fibres 1 consists of five layers of optical fibres 26 of the same thickness, as shown in Figure 3b. The innermost layer of optical fibres 26 is placed around a support tube 13 located in the centre of the bundle of optical fibres 1, runs along the whole length of the support tube 13, and is surrounded and fixed to the support tube 13 by a shrink tube 25. The second layer of optical fibres 26 starts from the second level from the bottom, it is placed on the first layer of optical fibres 26 surrounded by a shrink tube 25, and is also surrounded by a shrink tube 25. The next layer of optical fibres 26 starts from the next level and is formed in the same way as described above. The bundle of optical fibres 1 consists of as many layers of optical fibres 26 as there are levels in the support structure 20, and each layer of optical fibres 26, even the outermost one, is surrounded by a shrink tube 25. The shrink tube 25 covered cylindrical portions 14 of the bundle of optical fibres 1 are surrounded by silicone rubber rings 9 as well.

The truncated cone-shape of the bundle of optical fibres 1 between two levels is formed by grinding, thereby the shrink tube 25 is removed, and the light entering the bundle of optical fibres 1 is transmitted through ends of the elementary optical fibres. Figure 3b shows well the layers of optical fibres 26 of the same thickness surrounding the support tube 13, surrounded by shrink tubes 25.

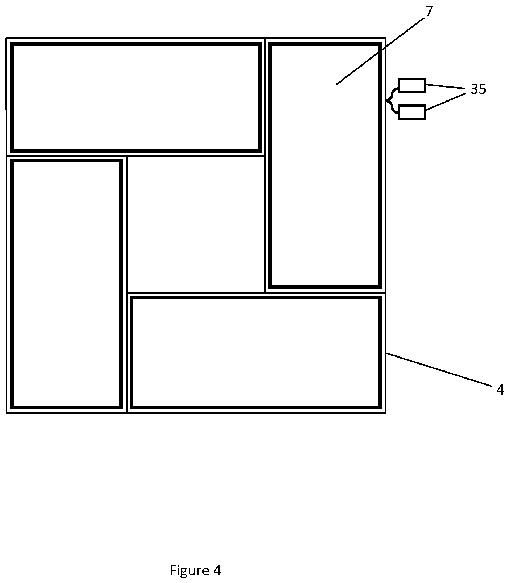

Figure 4 shows the arrangement of four rectangular solar panels 7 on a lower mounting frame 10.

The solar panels 7 are arranged on the lower mounting frame 10 in a characteristic manner, in the shape of a square, leaving a square-shaped mounting opening in the centre. The solar panels 7 are cushioned with silicone sealing rubber 4 fitting the lower mounting frame 10. The four solar panels 7 are connected in parallel for direct current, with two pole terminals 35 for further connection.

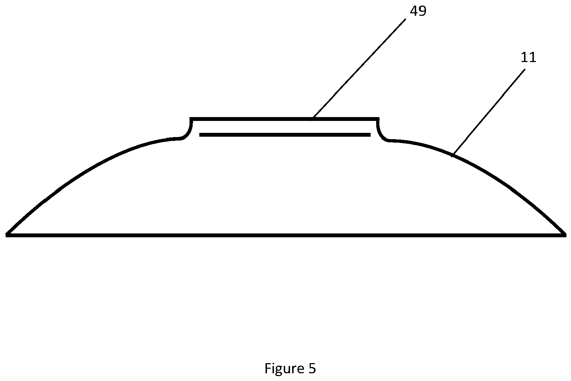

Figure 5 shows a side view of a parabolic mirror 11.

The parabolic mirrors 11 fit over and around the solar panels 7 arranged in the shape of a square. The lower portion of the parabolic mirrors 11 is square-shaped, formed at the four corners as a rounded reflector. The upper portion of the parabolic mirrors 11 has a flanged opening 49, through which the bundle of optical fibres 1 passes.

The inner height of the parabolic mirror 11 is the same as the height of the truncated cone-shaped portion 15 of the bundle of optical fibres 1 located between the relevant levels. The flanged opening 49 extends up to half the height of the cylindrical portion 14 of the bundle of optical fibres 1.

The parabolic mirrors 11 with silvered inner surface are made of ultramid plastic.

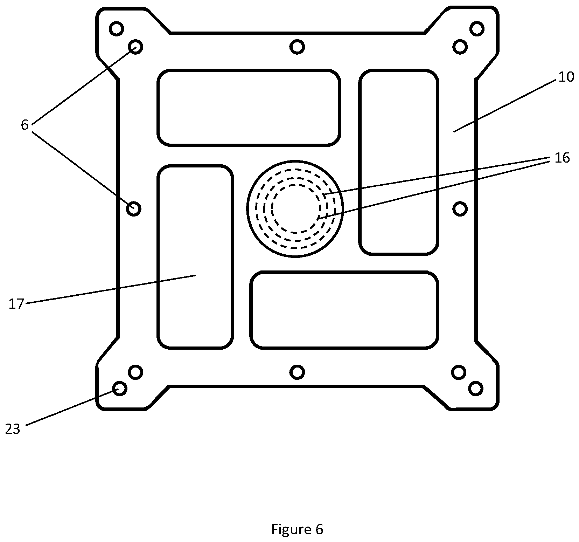

Figure 6 shows a top view of a lower mounting frame 10. The Figure shows the entire surface of the uppermost lower mounting frame 10 of the support structure 20, while from the lower mounting frames 10 located below it only bores 16 of successively smaller diameters are shown.

The lower mounting frame 10 has four openings 17 and a circular bore 16 in the centre. The openings 17, on the one hand, provide weight reduction for the support structure 20, and on the other hand, provide a cooling surface for the solar panels 7 placed on the openings 17. The lowermost lower mounting frame 10 of the support structure 20 has no openings 17, in order to protect the solar panels 7 placed on this level from possible mechanical damage. The cylindrical portions 14 of the bundle of optical fibres 1 passing through the bore 16 are surrounded by silicone rubber rings 9.

The lower mounting frame 10 has eight mounting screws 6 for fixing the lower mounting frame 10 to an upper mounting frame 3 and a spacer box 24. The lower mounting frame 10 is formed with four right-angled tabs at the corners. The tabs allow the assembling of the levels by four clamping screws 23. In the case of support structures 20 placed side by side on a mounting base plate, the corner tabs provide cooling for the solar panels 7 by keeping the support structures 20 apart.

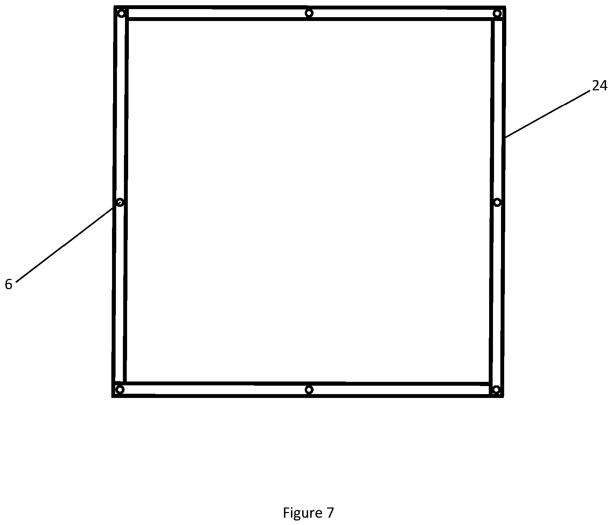

Figure 7 shows a top view of a spacer box 24.

A spacer box 24 is a square base box with eight mounting screws 6 for fixing to it an upper mounting frame 3 and a lower mounting frame 10. The spacer boxes 24 have closed side walls, and they are open at the top and at the bottom.

The spacer boxes 24 are preferably made of coloured cellular polycarbonate sheets. The outer and inner corners of the spacer boxes 24 are covered with self-adhesive end sealing tape, which is moisture-proof and UV resistant. The coloured cellular polycarbonate is impermeable to infrared radiation, thus protecting the solar panel column from heating, and is UV resistant and rain-proof.

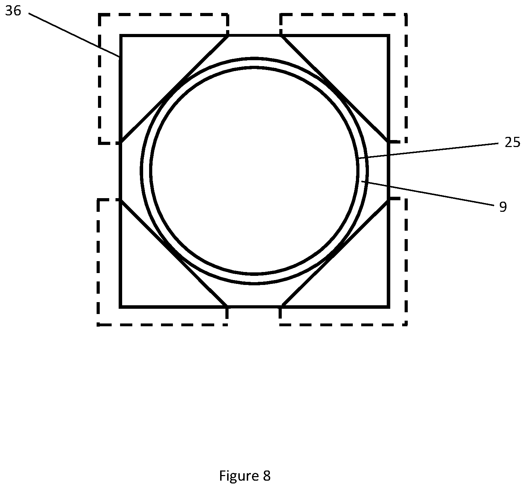

Figure 8 shows the preferred design and arrangement of four silica gel bags 36 placed on a level.

Right-angled triangle-shaped silica gel bags 36 are glued to the lower mounting frame 10 in such a way that the two sides of the silica gel bags 36 enclosing a right angle fit the edges of the openings 17 of the lower mounting frame 10, and their third side touches the silicone rubber ring 9 on the shrink tube 25 surrounding the bundle of optical fibres 1.

There is no silica gel in the edge portions of the silica gel bags 36, the solar panels 7 fit on these portions. These edges are glued to the lower mounting frame 10.

The silica gel bags 36 keep the surface of the solar panels 7 and the inner surface of the parabolic mirrors 11 free from moisture. Preferably, 0.15 grams of desiccant silica gel is required per litre of air.

The size and weight of the silica gel bags 36 need to be adjusted to the dimensions of the particular solar panel column.

In the case of the solar panel column consisting of five levels shown in Figure 1, there are four silica gel bags 36 on each of four levels, there are no silica gel bags 36 on the uppermost level.

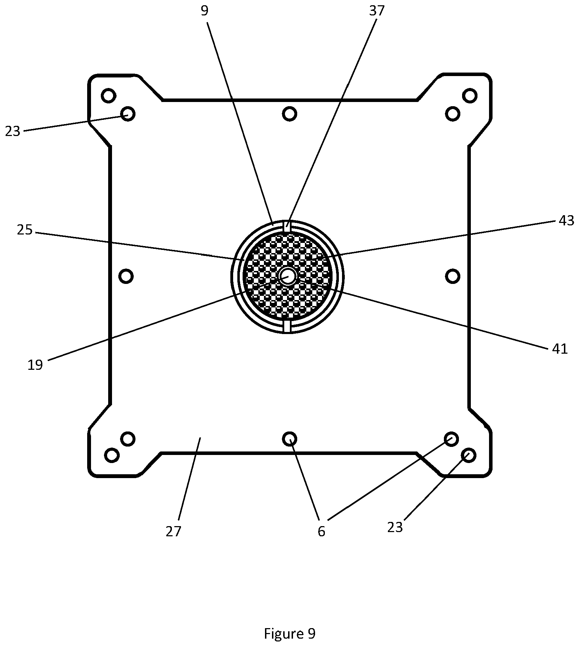

Figure 9 shows a top view of an embodiment where the uppermost level of the support structure 20 is covered by a closing element 27. The closing element 27 is placed on a lower mounting frame 10 placed on a spacer box 24 located on the lower mounting frame 10 holding the solar panels 7 of the uppermost level. Light is provided to the solar panels 7 located on the uppermost level by a parabolic mirror 11.

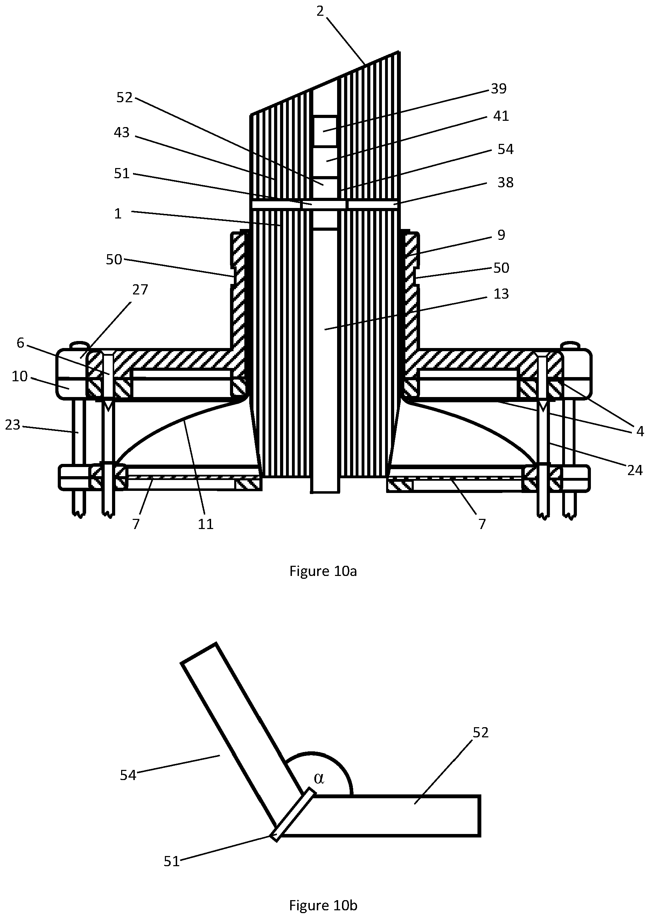

The closing element 27 has a horizontal closed portion having the same shape as an upper mounting frame 3, and a tubular portion in the centre (shown in Figure 10a) perpendicular to the horizontal portion, which has a slot 37 on both sides. The tubular portion of the closing element 27 surrounds the bundle of optical fibres 1. The function of the slots 37 is to fix the bundle of optical fibres 1. The bundle of optical fibres 1 is surrounded by a shrink tube 25 and a silicone rubber ring 9. The top view shows an optical fibre cable 43 connected to the bundle of optical fibres 1, fixed around a support element 41 (shown in detail in Figure 10a).

The horizontal portion of the closing element 27 fits exactly the lower mounting frame 10 of the uppermost level of the support structure 20, and is fixed to it by eight mounting screws 6. The horizontal portion of the closing element 27, in the same way as an upper mounting frame 3, is formed with four right-angled tabs at the corners. The tabs can be used to connect it to the level below it, together with the lower mounting frame 10, by four clamping screws 23.

The closing element 27 is made of plastic, preferably ultramid.

Figure 10a shows a longitudinal sectional view of the support structure 20 covered by a closing element 27.

Figure 10a shows that at the uppermost level of the support structure 20 the horizontal closed portion of the closing element 27 fits the lower mounting frame 10 cushioned with silicone sealing rubber 4, and is fixed to it by eight mounting screws 6. The bundle of optical fibres 1 fixed around the support tube 13 passes through the central vertical, tubular portion of the closing element 27. There is a silicone rubber ring 9 between the bundle of optical fibres 1 and the closing element 27. The bundle of optical fibres 1 extends beyond the uppermost level of the support structure 20. The tubular portion of the closing element 27 has a clamp, connected/located at the place of clamp 50 shown in the Figure.

The bundle of optical fibres 1 is connected to an optical fibre cable 43.

The optical fibre cable 43 fixed around a support element 41 also consist of end-glow optical fibres, but the outer optical fibres are not shortened by cutting and grinding, that is all ends of the end-glow optical fibres are at the end of the optical fibre cable 43, there is none on the side. The support element 41 of the optical fibre cable 43 fits the support tube 13 of the bundle of optical fibres 1 by means of a mounting stud 54 in such a way that there is an air gap 38 between the optical fibre cable 43 and the bundle of optical fibres 1.

The mounting stud 54 consists of a spacer element 51 and two stems 52 connected to the spacer element 51. In Figure 10a the two stems 52 enclose an alpha (α) angle of 180°, in Figure 10b the two stems 52 enclose an alpha (α) angle of less than 180°. The alpha angle depends on the required bending of the optical fibre cable 43. The spacer element 51 of the mounting stud 54 provides an air gap 38 between the bundle of optical fibres 1 and the optical fibre cable 43.

The optical fibre cable 43 can be connected to additional optical fibre cables 43 by mounting studs 54.

Ideally, the optical fibre cable 43 is led into a particular location in a straight line, but changes in the direction of the optical fibre cable 43 may be required, especially in vehicles.

For changes in direction, preferably mounting studs 54 designed at an angle are used, as shown in Figure 10b.

The end or ends of the optical fibre cable 43 shall be cut and ground at an angle corresponding to the angle of the mounting stud 54, then the optical fibre cable 43 ends formed this way shall be connected with the mounting stud 54.

The gaps between optical fibre cables 43 connected at an angle shall be insulated from the outside, or sealed in a reliable manner.

A shrink tube solution can also be used for sealing the connections between individual optical fibre cable 43 sections.

The mounting studs 54 are preferably made of ultramid, or other plastic by injection moulding.

The upper end of the optical fibre cable 43 is closed by a tube plug 39 fitting into the support element 41. The length of the optical fibre cable 43 is determined by the application of the solar panel column.

The upper, inlet end of the optical fibre cable 43 is cut at an angle to provide the most efficient exposure to light. The cut surface of the optical fibre cable 43 is covered with foil 2 after grinding, the optical fibre cable 43 is preferably surrounded by sheathing.

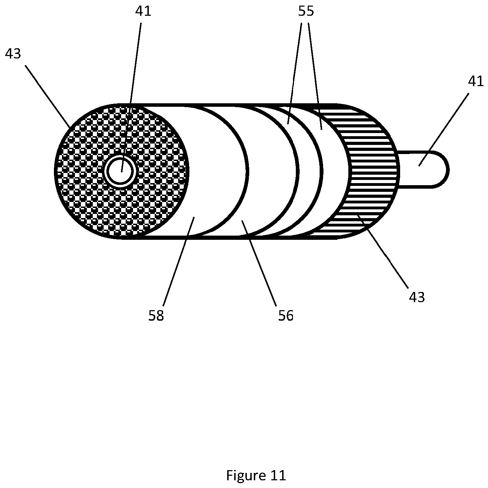

Figure 11 shows the design of a custom-designed sheathed optical fibre cable 43 for connection to the bundle of optical fibres 1.

The custom-designed sheathed optical fibre cable 43 comprises: a support element 41, which is a PVC tube, an optical fibre cable 43, protective Kevlar fabric layers 55, a protective aluminium sheet wrapped around the Kevlar fabric layers 55 in two rows in a spiral to ensure flexibility, and a PVC sheath 58 protecting the aluminium sheet 56.

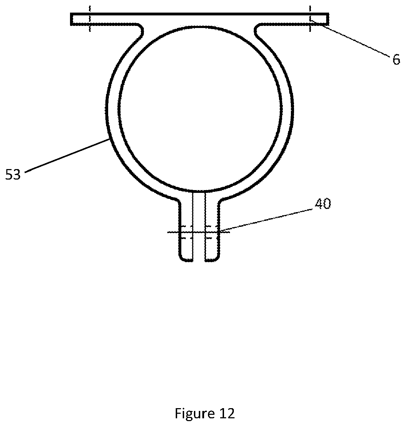

Figure 12 shows a top view of a mounting clamp 53. The mounting clamp 53 can be used for connecting and fixing to each other two optical fibre cable 43 sections. When optical fibre cables 43 are connected, the support elements 41 of two optical fibre cables 43 are connected by a mounting stud 54 located in the centre of the mounting clamp 53, and the ends of the two optical fibre cables 43 to be connected are located opposite to each other in a cavity in the centre of the mounting clamp 53. It would be difficult to connect two optical fibre cables 43 by connecting ends of elementary fibres to ends of elementary fibres of the optical fibre cables 43. The spacer element 51 of the mounting stud 54 provides an air gap 38 between the connected optical fibre cables 43. As a result of the air gap 38, the scattering of light emitted by the ends of the elementary fibres of the optical fibre cable 43 acts on a larger surface, thereby the inlet ends of the optical fibres of the connected optical fibre cable 43 are exposed to better light conditions.

The two connected optical fibre cables 43 are fixed by a bolt passing through mounting bores 40 located on the rim portion of the mounting clamp 53. The mounting clamp 53 has screw holes. The space between the two connected optical fibre cables 43 is sealed from the outside with insulating tape to prevent any dirt or water from entering.

The mounting clamp 53 is preferably made of stainless steel.

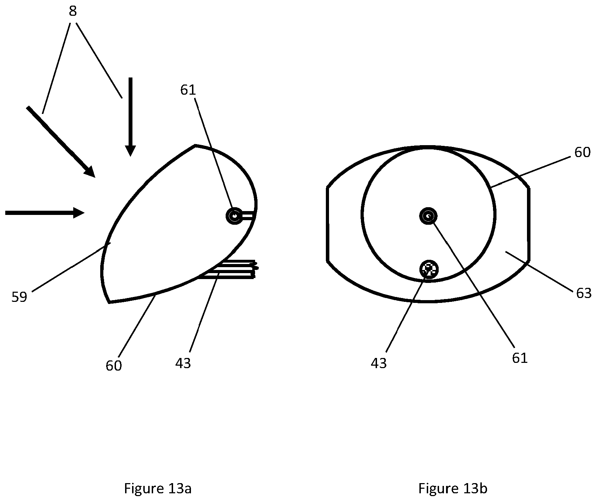

Figures 13a and 13b show a lateral cross-sectional view and a front view of an optical fibre cable 43 installed in the headlight 63 of a vehicle, which optical fibre cable 43 is connected to the bundle of optical cables 1 of a support structure 20 covered with a closing element 27.

The end of the optical fibre cable 43 installed in the headlight 63 follows the curve of a parabolic mirror. A special, custom-designed parabolic mirror solution, protruding in the lower part, provides favourable light conditions for the inlet portion of the optical fibre cable 43. The headlight reflector 60 is closed by a headlight glass 59, the headlight reflector 60 contains a headlight bulb 61, and the inlet portion of the optical fibre cable 43 is located below it. The headlight reflector 60 is formed as a parabolic mirror. The optical fibre cable 43 installed in the headlight 63 can utilize the rays 8 of both natural light and artificial light. It can make use of favourable sunlight conditions both when the vehicle is moving and when it is parked.

The solar panels produce direct current by converting light energy. By connecting the solar panels producing direct current in series and in parallel, and with proper voltage regulation, different voltage levels can be achieved.

The solar panels located on the uppermost level of the solar panel column according to the invention are exposed to natural or artificial light directly, the natural or artificial light, as well as the diffuse light surrounding the light source enters the bundle of optical fibres, or the outdoor inlet end of an optical fibre cable, thus light travels through the bundle of optical fibres to the inner spaces between the levels, to the solar panels and the inner surface of the parabolic mirrors.

Light is provided to the solar panels located on the lower levels through a specially designed bundle of optical fibres. The power produced by the lower levels exposed to light through the optical fibres of the bundle of optical fibres decreases from the top towards the bottom, the solar panels located on the uppermost level (exposed to light directly) provide 20 to 25 % more power.

Rays of light emitted by the bundle of end-glow optical cables formed in the shape of a truncated cone transmit their energy to the parabolic mirror surrounding the truncated cone-shaped portion, and to the solar panels located under the parabolic mirror.

In the case of the invention, in order to achieve approximately the same level of power on each level, preferably approximately the same light conditions are provided at the ends of the layers of optical fibres formed into truncated cone-shaped portions. Therefore, the height of the truncated cone-shaped portions increases towards the bottom. The intensity of light is further increased by the increasing surface area of the parabolic mirrors from the top to the bottom.

The solar panel columns can operate in PV-systems in island operation, e.g. in vehicles. Due to their portability, they have a wide range of other applications compared to conventional "board" systems.

Blocks formed from solar panel columns can be operated in PV-systems connected to the grid, but also in island operation.

They can also be connected to conventional solar panel boards, to create combined, mixed systems.

The easiest way to stop the operation of a solar panel column system in island operation, whether it is a fixed or a mobile system, is to interrupt the flow of light by covering the uppermost level of the support structure, or the end of the optical fibre cable. A more advantageous solution is to "oversize" the energy storing capacity by installing more battery(ies) into the system to absorb the excess power, in the case of systems connected to the grid energy overproduction is not a problem.

The solar panel columns are repairable, defective parts can be replaced. The so called "hot spot" failure can occur only in solar panel columns not covered by a closing element.

The solar panel columns according to the invention, due to their spatial usability and mobility, are well suited for land, water, and air vehicles.
- The solar panel columns can also be used in space technology.
- Solar panel columns comprising a support structure covered with a closing element can also operate in submarines, in a utility tower while staying on the surface of water.
- The solar panel columns can be applied in the fields of the industry, agriculture, health care (silent operation), disaster management, and certain private enterprises.
- Special mention should be made of their application in electric cars for recharging the battery(ies) with a closed-system solar panel column solution. In cars, the operating bundle of optical fibres can be connected to optical fibre cables installed in the parabolic mirrors of specially designed headlights, creating smart headlights. The solar panel columns can be placed in the engine compartment. The "C" pillars of cars can be designed for this purpose, with 2 to 3 optical fibre cables per pillar. The solar panel columns can be placed behind the rear seats or in the place of the old fuel tanks. Thus, in the case of an electric car: preferably a block of solar panel columns containing 6 to 8 support structures connected to one another, consisting of at least 3 to 5 levels can be used, which provides adequate recharging of the batteries in sunny weather both on the move and while parking.
- Special mention should be made of the dual operation of optical fibre cables installed in headlight mirrors. The lighting elements of the headlights (bulbs), in country mode (low beam, high beam), can be operated as a function of the intensity of artificial and natural light to which the inlet end of the bundle of optical fibres is exposed to.

Electric cars designed with the solar panel columns have a significantly longer range, although an external charging current source is still required, but with less charging current consumption. Currently the average range of electric cars per charge is 300-600 km.

By using the invention, the range can be significantly increased, even beyond the range of internal combustion engines with one refuelling.

Solar panel columns or blocks can be advantageously used in caravans and motorhomes also for charging additional batteries.

The solution applicable to vehicles can work well in sunny weather. Naturally, the position of a vehicle on the move influences the position of the headlights, which can often be shaded from the rays of light.

Solar panel columns equipped with optical fibre cables can provide charging current even when the car is parked, if they are exposed to sunlight.

Optical fibre cables leading to the roof of the body can be located in several places in the body of a vehicle. Thus, for example, in the "C" pillars of cars and along the edges of the rear windscreen. Such places need to be designed, just as the places of solar panel columns covered with a closing element need to be designed in the engine compartment and behind the rear seats, etc. In buses, the pillars between the side windows offer an opportunity for leading optical fibre cables to the roof. And the space below the floor offers an opportunity for placing solar panel columns covered with a closing element there. The area around the bundles of optical fibres led to the roof of the body needs to be sealed against rain with a special sealing cap.

There are possible solutions for water and air vehicles as well, which also require designing.

The bundle of end-glow optical fibres or optical fibre cable installed in the headlights of vehicles can also be installed in the parabolic mirrors of floodlights. Thus, for example, optical fibre cables installed in the lighting fixtures of exhibition halls, sports halls, stadiums, warehouses, etc. having a strong light can use the artificial light for producing direct current by means of solar panel columns covered with a closing element.

The direct current so produced can be used for operating computers, lighting, scoreboards, etc.

The side light ("waste light") of floodlights can be utilized in the lighting system of so called "smart houses", by connecting them to a block of direct current producing solar panel columns.

In cars, under appropriate light conditions, bundles of optical fibres led to the roof of the body can transmit light to solar panel columns covered with a closing element even when the car is parked, thus in underground car parks parking spaces can be formed where light can "come" from the surface by means of optical fibre cables. In parking spaces designed for this purpose, for recharging the car simply needs to be parked under the light coming from above.

## Claims

1. A solar panel column, which is a device working on the principle of photovoltaic effect, producing direct current, and which comprises a support structure (20) containing at least two levels parallel to each other, solar panels (7) placed on the levels, parabolic mirrors (11) located between the levels, and a bundle of optical fibres (1) consisting of end-glow optical fibres located in the centre of the support structure (20), where the solar panels (7) located on the same level are connected in parallel, with two pole terminals (35), and the solar panels (7) located on the levels placed on top of one another are connected in series,
**characterized in that**
the levels of the support structure (20) consist of a lower mounting frame (10) and an upper mounting frame (3) connected to each other, the lower mounting frame (10) has a circular bore (16) in the centre, and the solar panels (7) are placed on the lower mounting frame (10),
the support structure (20) also comprises a support tube (13) located in the centre thereof and passing through the bores (16), and at least one spacer box (24) with closed side walls separating the levels,
the bundle of optical fibres (1) surrounding the support tube (13) runs along the height of the support structure (20), the bundle of optical fibres (1) consists of alternating cylindrical portions (14) and truncated cone-shaped portions (15), the surface of the truncated cone-shaped portions (15) is covered by the ends of end-glow optical fibres, the parabolic mirrors (11) have a square-shaped lower portion of the same floor area, and cover the whole surface of the solar panels (7) located on the relevant level, their upper, curved portion has a flanged opening (49), the flanged opening (49) surrounds the bundle of optical fibres (1), the height of the parabolic mirror (11) is the same as the height of the truncated cone-shaped portion (15) located between the relevant levels, and the optical fibre ends of the truncated cone-shaped portions (15) illuminate the space between the levels.

2. The solar panel column according to claim 1, **characterized in that** the diameter of the bundle of optical fibres (1) decreases from section to section from the top level towards the bottom level.

3. The solar panel column according to claims 1 or 2, **characterized in that** the height of the truncated cone-shaped portions (15) of the bundle of optical fibres (1) located between two levels decreases from the top level towards the bottom level in such a way that the surface area of the truncated cone-shaped portions (15) between any two levels is the same.

4. The solar panel column according to any of claims 1 to 3, **characterized in that** the height of the spacer boxes (24), and the distance between the levels is the same as the height of the truncated cone-shaped portion (15) located between the relevant levels.

5. The solar panel column according to any of claims 1 to 4, **characterized in that** the bundle of optical fibres (1) consists of layers of optical fibres (26) surrounded by shrink tubes (25).

6. The solar panel column according to any of claims 1 to 5, **characterized in that** the cylindrical portions (14) of the bundle of optical fibres (1) are surrounded by silicone rubber rings (9), and the truncated cone-shaped portions (15) are surrounded by foil (2).

7. The solar panel column according to any of claims 1 to 6, **characterized in that** the bundle of optical fibres (1) consists of as many layers of optical fibres (26) as there are levels in the support structure (20).

8. The solar panel column according to any of claims 1 to 7, **characterized in that** the solar panels (7) are arranged in the shape of a square on the lower mounting frames (10).

9. The solar panel column according to any of claims 1 to 8, **characterized in that** the lower mounting frame (10) has openings (17).

10. The solar panel column according to claim 9, **characterized in that** the solar panels (7) are placed on the openings (17) of the lower mounting frame (10).

11. The solar panel column according to any of claims 1 to 10, **characterized in that** there is silicone sealing rubber (4) on the closed surface of the lower mounting frame (10).

12. The solar panel column according to any of claims 1 to 11, **characterized in that** between two levels silica gel bags (36) are fixed to the lower mounting frame (10).

13. The solar panel column according to any of claims 1 to 12, **characterized in that** the top level of the support structure (20) is equipped with a closing element (27), and in the centre of the closed horizontal portion of the closing element (27) there is an open tubular portion perpendicular to the horizontal portion, through which the bundle of optical fibres (1) passes.

14. The solar panel column according to claim 13, **characterized in that** an optical fibre cable (43) consisting of sheathed end-glow optical fibres surrounding a support element (41) is connected to the bundle of optical fibres (1) by a mounting stud (54), where two stems (52) connected to a spacer element (51) of the mounting stud (54) enclose an angle of 180°, or less than 180°.

15. The solar panel column according to claims 13 or 14, **characterized in that** the optical fibre cable (43) is connected to additional optical fibre cable (43) sections.

16. The solar panel column according to any of claims 13 to 15, **characterized in that** the sheathing surrounding the optical fibre cable (43) consists of Kevlar fabric (55), an aluminium sheet (56) covering it, and a PVC sheath (58) surrounding the aluminium sheet (56).

17. The solar panel column according to any of claims 1 to 16, **characterized in that** the support structures (20) and the pole terminals (35) of the solar panels (7) placed on them can be connected to form a block.

18. The solar panel column according to any of claims 13 to 17, **characterized in that** the inlet end of the optical fibre cable (43) is installed in the headlight of a vehicle, or led to the roof of the vehicle.

19. The solar panel column according to any of claims 1 to 12, **characterized in that** the support structure (20) is equipped with a cover.

## Patentansprüche

1. Solarpaneelsäule, die eine nach dem Prinzip des photovoltaischen Effekts arbeitende, Gleichstrom erzeugende Vorrichtung ist und die eine Trägerstruktur (20) mit mindestens zwei zueinander parallelen Ebenen, auf den Ebenen angeordneten Solarzellen (7), zwischen den Ebenen angeordneten Parabolspiegeln (11) und ein Bündel von Lichtleitfasern (1), das aus endständigen Lichtleitfasern besteht, die in der Mitte der Trägerstruktur (20) angeordnet sind, wobei die auf derselben Ebene angeordneten Sonnenkollektoren (7) mit zwei Polklemmen (35) parallel geschaltet sind und die auf den übereinander angeordneten Ebenen angeordneten Sonnenkollektoren (7) in Reihe geschaltet sind,
**dadurch gekennzeichnet, dass**
die Ebenen der Tragstruktur (20) aus einem unteren Montagerahmen (10) und einem oberen Montagerahmen (3) bestehen, die miteinander verbunden sind, der untere Montagerahmen (10) in der Mitte eine kreisförmige Bohrung (16) aufweist und die Solarpaneele (7) auf dem unteren Montagerahmen (10) angeordnet sind,
die Tragstruktur (20) auch ein in ihrer Mitte angeordnetes und durch die Bohrungen (16) verlaufendes Tragrohr (13) und mindestens einen die Ebenen trennenden Abstandskasten (24) mit geschlossenen Seitenwänden umfasst,
das Bündel von Lichtleitfasern (1), das das Trägerrohr (13) umgibt, verläuft entlang der Höhe der Trägerstruktur (20), das Bündel von Lichtleitfasern (1) besteht aus abwechselnd zylindrischen Abschnitten (14) und kegelstumpfförmigen Abschnitten (15), die Oberfläche der kegelstumpfförmigen Abschnitte (15) ist von den Enden der endständigen Lichtleitfasern bedeckt, die Parabolspiegel (11) haben einen quadratischen unteren Abschnitt von gleicher Grundfläche, und decken die gesamte Fläche der auf der jeweiligen Ebene befindlichen Sonnenkollektoren (7) ab, ihr oberer, gekrümmter Teil weist eine geflanschte Öffnung (49) auf, die geflanschte Öffnung (49) umgibt das Bündel von Lichtleitfasern (1), die Höhe des Parabolspiegels (11) ist gleich der Höhe des zwischen den jeweiligen Ebenen befindlichen kegelstumpfförmigen Teils (15), und die Lichtleiterenden der kegelstumpfförmigen Teile (15) beleuchten den Raum zwischen den Ebenen.

2. Solarpaneelsäule nach Anspruch 1, **dadurch gekennzeichnet, dass** der Durchmesser des Bündels von Lichtleitfasern (1) von Abschnitt zu Abschnitt von der oberen Ebene zur unteren Ebene abnimmt.

3. Solarpaneelsäule nach Anspruch 1 oder 2, **dadurch gekennzeichnet, dass** die Höhe der kegelstumpfförmigen Abschnitte (15) des Bündels von Lichtleitfasern (1), die sich zwischen zwei Ebenen befinden, von der oberen Ebene zur unteren Ebene hin so abnimmt, dass die Oberfläche der kegelstumpfförmigen Abschnitte (15) zwischen zwei beliebigen Ebenen gleich ist.

4. Solarpaneelsäule nach einem der Ansprüche 1 bis 3, **dadurch gekennzeichnet, dass** die Höhe der Abstandshalterkästen (24) und der Abstand zwischen den Ebenen die gleiche ist wie die Höhe des kegelstumpfförmigen Teils (15), der sich zwischen den betreffenden Ebenen befindet.

5. Solarpaneelsäule nach einem der Ansprüche 1 bis 4, **dadurch gekennzeichnet, dass** das Bündel von Lichtleitfasern (1) aus Lagen von Lichtleitfasern (26) besteht, die von Schrumpfschläuchen (25) umgeben sind.

6. Solarpaneelsäule nach einem der Ansprüche 1 bis 5, **dadurch gekennzeichnet, dass** die zylindrischen Abschnitte (14) des Lichtleitfaserbündels (1) von Silikonkautschukringen (9) und die kegelstumpfförmigen Abschnitte (15) von einer Folie (2) umgeben sind.

7. Solarpaneelsäule nach einem der Ansprüche 1 bis 6, **dadurch gekennzeichnet, dass** das Lichtleitfaserbündel (1) aus so vielen Lagen von Lichtleitfasern (26) besteht, wie es Ebenen in der Trägerstruktur (20) gibt.

8. Solarpaneelsäule nach einem der Ansprüche 1 bis 7, **dadurch gekennzeichnet, dass** die Solarmodule (7) in Form eines Quadrats auf den unteren Befestigungsrahmen (10) angeordnet sind.

9. Solarpaneelsäule nach einem der Ansprüche 1 bis 8, **dadurch gekennzeichnet, dass** der untere Montagerahmen (10) Öffnungen (17) aufweist.

10. Solarpaneelsäule nach Anspruch 9, **dadurch gekennzeichnet, dass** die Solarmodule (7) auf den Öffnungen (17) des unteren Montagerahmens (10) angeordnet sind.

11. Solarpaneelsäule nach einem der Ansprüche 1 bis 10, **dadurch gekennzeichnet, dass** die geschlossene Oberfläche des unteren Montagerahmens (10) mit Silikondichtungsgummi (4) versehen ist.

12. Solarpaneelsäule nach einem der Ansprüche 1 bis 11, **dadurch gekennzeichnet, dass** zwischen zwei Ebenen Kieselgelsäcke (36) an dem unteren Montagerahmen (10) befestigt sind.

13. Solarpaneelsäule nach einem der Ansprüche 1 bis 12, **dadurch gekennzeichnet, dass** die obere Ebene der Trägerstruktur (20) mit einem Verschlusselement (27) ausgestattet ist und in der Mitte des geschlossenen horizontalen Abschnitts des Verschlusselements (27) ein offener röhrenförmiger Abschnitt senkrecht zu dem horizontalen Abschnitt vorhanden ist, durch den das Bündel optischer Fasern (1) verläuft.

14. Solarpaneelsäule nach Anspruch 13, **dadurch gekennzeichnet, dass** ein Lichtleitfaserkabel (43), das aus ummantelten endständigen Lichtleitfasern besteht, die ein Trägerelement (41) umgeben, mit dem Lichtleitfaserbündel (1) durch einen Montagebolzen (54) verbunden ist, wobei zwei mit einem Abstandselement (51) des Montagebolzens (54) verbundene Stiele (52) einen Winkel von 180° oder weniger als 180° einschließen.

15. Solarpaneelsäule nach Anspruch 13 oder 14, **dadurch gekennzeichnet, dass** das Lichtwellenleiterkabel (43) mit weiteren Lichtwellenleiterkabelabschnitten (43) verbunden ist.

16. Solarpaneelsäule nach einem der Ansprüche 13 bis 15, **dadurch gekennzeichnet, dass** die das Glasfaserkabel (43) umgebende Ummantelung aus Kevlargewebe (55), einem dieses bedeckenden Aluminiumblech (56) und einer das Aluminiumblech (56) umgebenden PVC-Ummantelung (58) besteht.

17. Solarpaneelsäule nach einem der Ansprüche 1 bis 16, **dadurch gekennzeichnet, dass** die Trägerstrukturen (20) und die Polklemmen (35) der darauf angeordneten Solarmodule (7) zu einem Block verbunden werden können.

18. Solarpaneelsäule nach einem der Ansprüche 13 bis 17, **dadurch gekennzeichnet, dass** das Eingangsende des Glasfaserkabels (43) im Scheinwerfer eines Fahrzeugs installiert oder zum Dach des Fahrzeugs geführt ist.

19. Solarpaneelsäule nach einem der Ansprüche 1 bis 12, **dadurch gekennzeichnet, dass** die Trägerstruktur (20) mit einer Abdeckung versehen ist.

## Revendications

1. Une colonne de panneaux solaires, qui est un dispositif fonctionnant sur le principe de l'effet photovoltaïque, produisant du courant continu, et qui comprend une structure de support (20) contenant au moins deux niveaux parallèles l'un à l'autre, des panneaux solaires (7) placés sur les niveaux, des miroirs paraboliques (11) situés entre les niveaux, et un faisceau de fibres optiques (1) constitué de fibres optiques à lueur d'extrémité situé au centre de la structure de support (20), où les panneaux solaires (7) situés sur un même niveau sont connectés en parallèle, avec deux bornes polaires (35), et les panneaux solaires (7) situés sur les niveaux placés l'un au-dessus de l'autre sont connectés en série,
**caractérisé en ce que**
les niveaux de la structure de support (20) consistent en un cadre de montage inférieur (10) et un cadre de montage supérieur (3) reliés l'un à l'autre, le cadre de montage inférieur (10) présente un alésage circulaire (16) au centre, et les panneaux solaires (7) sont placés sur le cadre de montage inférieur (10),
la structure de support (20) comprend également un tube de support (13) situé au centre et traversant les alésages (16), et au moins une boîte d'écartement (24) aux parois latérales fermées séparant les niveaux,
le faisceau de fibres optiques (1) entourant le tube de support (13) s'étend sur la hauteur de la structure de support (20), le faisceau de fibres optiques (1) est constitué des parties cylindriques alternées (14) et de parties tronconiques (15), la surface des parties tronconiques (15) est couverte par les extrémités des fibres optiques à lueur d'extrémité, les miroirs paraboliques (11) ont une partie inférieure de forme carrée de la même surface au sol et couvrent toute la surface des panneaux solaires (7) situés au niveau concerné, leur partie supérieure incurvée a une ouverture à rebord (49), l'ouverture à rebord (49) entoure le faisceau de fibres optiques (1), la hauteur du miroir parabolique (11) est la même que la hauteur de la partie tronconique (15) située entre les niveaux concernés, et les extrémités des fibres optiques des parties tronconiques (15) éclairent l'espace situé entre les niveaux.

2. La colonne de panneaux solaires selon la revendication 1, **caractérisée en ce que** le diamètre du faisceau de fibres optiques (1) diminue d'une section à l'autre, du niveau supérieur vers le niveau inférieur.

3. La colonne de panneaux solaires selon les revendications 1 ou 2, **caractérisée en ce que** la hauteur des parties tronconiques (15) du faisceau de fibres optiques (1) situées entre deux niveaux diminue du niveau supérieur vers le niveau inférieur de telle sorte que la surface des parties tronconiques (15) entre deux niveaux soit la même.

4. Colonne de panneaux solaires selon l'une des revendications 1 à 3, **caractérisée en ce que** la hauteur des boîtes d'écartement (24) et la distance entre les niveaux est la même que la hauteur de la partie tronconique (15) située entre les niveaux concernés.

5. Colonne de panneaux solaires selon l'une des revendications 1 à 4, **caractérisée en ce que** le faisceau de fibres optiques (1) est constitué de couches de fibres optiques (26) entourées de tubes rétractables (25).

6. Colonne de panneau solaire selon l'une des revendications 1 à 5, **caractérisée en ce que** les parties cylindriques (14) du faisceau de fibres optiques (1) sont entourées d'anneaux en caoutchouc de silicone (9), et que les parties tronconiques (15) sont entourées d'une feuille (2).

7. La colonne de panneaux solaires selon l'une des revendications 1 à 6, **caractérisée en ce que** le faisceau de fibres optiques (1) est constitué d'autant de couches de fibres optiques (26) qu'il y a de niveaux dans la structure de support (20).

8. La colonne de panneaux solaires selon l'une des revendications 1 à 7, **caractérisée en ce que** les panneaux solaires (7) sont disposés en forme de carré sur les cadres de montage inférieurs (10).

9. La colonne de panneaux solaires selon l'une des revendications 1 à 8, **caractérisée en ce que** le cadre de montage inférieur (10) comporte des ouvertures (17).

10. La colonne de panneaux solaires selon la revendication 9, **caractérisée en ce que** les panneaux solaires (7) sont placés sur les ouvertures (17) du cadre de montage inférieur (10).

11. La colonne de panneaux solaires selon l'une des revendications 1 à 10, **caractérisée en ce que** la présence d'un caoutchouc d'étanchéité en silicone (4) sur la surface fermée du cadre de montage inférieur (10).

12. La colonne de panneaux solaires selon l'une des revendications 1 à 11, **caractérisée en ce qu'**entre deux niveaux, des sacs de gel de silice (36) sont fixés au cadre de montage inférieur (10).

13. La colonne de panneaux solaires selon l'une des revendications 1 à 12, **caractérisée en ce que** le niveau supérieur de la structure de support (20) est équipé d'un élément de fermeture (27) et qu'au centre de la partie horizontale fermée de l'élément de fermeture (27) se trouve une partie tubulaire ouverte perpendiculaire à la partie horizontale, à travers laquelle passe le faisceau de fibres optiques (1).

14. La colonne de panneaux solaires selon la revendication 13, **caractérisée en ce qu'**un câble à fibres optiques (43) constitué de fibres optiques à lueur d'extrémité gainées entourant un élément de support (41) est relié au faisceau de fibres optiques (1) par un goujon de montage (54), où deux tiges (52) reliées à un élément d'écartement (51) du goujon de montage (54) forment un angle de 180°, ou inférieur à 180°.

15. La colonne de panneaux solaires selon les revendications 13 ou 14, **caractérisée en ce que** le câble à fibres optiques (43) est connecté à des sections supplémentaires de câble à fibres optiques (43).

16. La colonne de panneaux solaires selon l'une des revendications 13 à 15, **caractérisée en ce que** la gaine entourant le câble à fibres optiques (43) est constituée d'un tissu Kevlar (55), d'une feuille d'aluminium (56) la recouvrant et d'une gaine en PVC (58) entourant la feuille d'aluminium (56).

17. La colonne de panneaux solaires selon l'une des revendications 1 à 16, **caractérisée en ce que** les structures de support (20)et les bornes polaires (35) des panneaux solaires (7) qui y sont placés peuvent être reliées pour former un bloc.

18. La colonne de panneaux solaires selon l'une des revendications 13 à 17, **caractérisée en ce que** l'extrémité d'entrée du câble à fibres optiques (43) est installée dans le phare d'un véhicule ou conduite sur le toit du véhicule.

19. La colonne de panneaux solaires selon l'une des revendications 1 à 12, **caractérisée en ce que** la structure de support (20) est équipée d'un couvercle.
